# EUROPEAN PATENT APPLICATION

(11) **EP 4 625 094 A1**
(43) Date of publication of application: **01.10.2025**
(21) Application number: 24200384.6
(22) Date of filing: 13.09.2024
(51) Int. Cl.: G05G 9/047, G05G 5/05, A63F 13/20, G06F 3/03

(54) **ROCKER DEVICE WITH AUTOMATIC CENTER RETURNING FUNCTION**

(30) Priority: 27.03.2024 CN 202410354022
(71) Applicant: MultiDimension Technology Co., Ltd., Jiangsu 215634 (CN)
(72) Inventor: LI, Haochen, Jiangsu, 215634 (CN); LI, Junyong, Jiangsu, 215634 (CN); ZHOU, Yiqian, Jiangsu, 215634 (CN)
(74) Representative: Loyer & Abello

(57) **Abstract**

The present invention provides a rocker device with the automatic center returning function. The rocker device adopts the magnetic sensor to acquire and output the angle information of the rocker rotation, and realizes the rocker automatically returning to the center through the magnet fixedly connected to the rocker and the structure design of the outer magnet ring. Additionally, below the rocker, the outer magnet is arranged on the part of the fixed member wrapping the outer side of the magnet ring and supporting the rocker, so that the press detection and the pressing back to the center for the rocker can be realized in conjunction with the additionally arranged magnetic sensor. Additionally, through adjusting the size of the magnets fixedly connected to the rocker and the size of the magnet ring, the feeling of the rocker device can be conveniently adjusted.

## Description

### TECHNICAL FIELD

The present invention relates to the field of the electrical signal input-and-output device, and specifically relates to a rocker device with an automatic center returning function (i.e., a rocker device having a function of returning to the center automatically).

### BACKGROUND ART

The control rocker is a very important type of input-and-output device, and is widely configured as control terminals of some electronic devices, such as a gamepad, a rocker, and a drone handle. At present, the control rockers on the market, such as the gamepad and the drone handle, are usually realized based on the carbon film potentiometer structure or Hall sensor.

Regarding the rocker based on the carbon film potentiometer, the recognization of a displacement of the rocker is achieved by the contact between the conductive film on the carbon film sensor and different resistance regions. When the rocker moves, the conductive film will slide across different resistance regions, thereby resulting in a corresponding change of the resistance values; and then the change of these resistance values is converted into electrical signals that are taken as output control signals.

The rocker based on the Hall sensor (referred to as Hall rocker below) is achieved primarily based on the Hall effect (when a current passes through a conductor in a magnetic field, it will generate a voltage difference in the conductor, and this phenomenon is called as the Hall voltage or Hall effect voltage). The structure of the Hall rocker usually includes a rocker body, a Hall component, a magnet, a circuit board, and other components. The rocker body usually includes one rotation shaft with the Hall component and one magnet. When the rotation shaft rotates, the magnet follows to move, thereby changing the strength of the magnetic field around the Hall component, which results in a change of the voltage generated by the Hall component; and then the voltage signal generated by the Hall component is converted into the electrical signal that is output as the control signal.

The rocker based on carbon film potentiometer has features of simple structure and low cost, but it also has problems of short life, easy drift and loss of detection accuracy because the contacted metal slides directly on the carbon film frequently. The Hall rocker acquires the motion state of the rocker through measuring changes in the magnetic field by the internal magnetic sensor. It solves the problems of the drift and the loss of detection accuracy to a certain extent, but the internal structure is still a force feedback structure based on a cardan shaft and a spring. This structure is not only relative complex, but also easily leads to conditions that the metal spring is fatigued, the rocker cannot accurately return to center, and the life is greatly reduced.

### SUMMARY

In order to solve the above shortcomings of the prior rocker device, i.e., in order to improve the detection accuracy and service life of the rocker device and meanwhile enable the rocker device to return to the center accurately, the present invention provides a rocker device with the simpler structure, reliable operation, and automatic center returning function.

The technical solutions provided by the present invention are realized by a rocker device with an automatic center returning function. The rocker device includes a ring magnet with a circular aperture, a fixed member, a magnet inside ring fixedly connected to the rocker, and a magnetic sensor chip, wherein
the ring magnet is magnetized in thickness, and a line connecting N-S poles is perpendicular to a circular section of the circular aperture; the fixed member is made of a non-magnetic material, and is arranged with the ring magnet in a stacked manner in a perpendicular direction of the circular section and the ring magnet is fixed;
the N-S poles of the magnet inside ring are completely symmetrical in shape, and are supported by the fixed member and arranged in a center of the circular aperture of the ring magnet, wherein when the rocker is in a state of having been rotated to return to a center, the line connecting the N-S poles of the magnet inside ring is perpendicular to the circular section of the circular aperture; and
the magnetic sensor chip is configured to detect a rotation angle of the rocker, and is located below the magnet inside ring in a direction perpendicular to the circular section of the circular aperture.

Further, the magnet inside ring is a spherical magnet, or a cylindrical magnet or square magnet wrapped in a spherical non-magnetic material.

Further, the fixed member includes a first component and a second component. The first component and the second component are interlocked by providing a hollow groove in the partial second component. The ring magnet is fixed on the first component, and an outer magnet is added to the second component corresponding to the outer ring side of the ring magnet. The outer magnet slides downward relative to the first component as the rocker is pressed, which is driven by the second component. When the rocker is not pressed, the N pole of the outer magnet is aligned with the S pole of the ring magnet, and the S pole of the outer magnet is aligned with the N pole of the ring magnet. When the rocker is pressed, there is only one pair of same magnetic poles facing each other between the outer magnet and the ring magnet. When the rocker is pressed, the relative positions between the N and S poles of the outer magnet and the ring magnet are changed, and the magnetic force generated by the outer magnet and the ring magnet pushes their relative position back to the state before the rocker is pressed. Then, the rocker is pushed back to the center by the transmission effect of the fixed member.

Correspondingly, the rocker device further includes a press sensor on the first component, wherein the press sensor is fixedly arranged outside and independent of the outer magnet, wherein the press sensor is a magnetic sensor configured to detect a press state of the rocker by detecting a movement of the outer magnet.

Preferably, the magnetic sensor chip is realized based on a XMR reluctance unit or a Hall sensor, wherein the XMR includes TMR, AMR, and GMR.

The rocker device provided by the present invention can conveniently adjust the manipulation feel by adjusting a size of the magnet fixedly connected to the rocker and the size of a magnet ring. Compared with the prior rocker devices, the rocker device provided by the present invention not only has a higher detection accuracy and service life, and adopts a simpler structure and has lower cost without adopting a spring or carbon film structure. It reliably realizes the automatic returning to the center, the pressing back to center, and the press detection of the rocker, and at the same time does not have problems caused by the metal fatigue.

### BRIEF DESCRIPTION OF DRAWINGS

In order to more clearly illustrate the technical solutions in the embodiments of the present invention, the following will briefly introduce the drawings to be used in the embodiments. It is to be understood that the following drawings illustrate only certain embodiments of the present invention, and therefore should not be regarded as a limitation of the scope. For persons of ordinary skill in the field, other relevant drawings can be obtained based on these drawings without inventive efforts.
FIG. 1 shows a front-section schematic diagram of a rocker device provided by the first embodiment of the present invention;
FIG. 2 shows a front-section schematic diagram of a rocker device provided by the second embodiment of the present inventiont;
FIG. 3a and FIG. 3b show respectively a front-section schematic diagram of a rocker device before and after pressed provided by the third embodiment of the present inventiont; and

### DETAILED DESCRIPTION OF EMBODIMENTS

The technical solutions of the present invention will be clearly and completely described below in connection with the embodiments. It is clear that the embodiments described are partial embodiments of the present invention, but not all of the embodiments. Based on the embodiments of the present invention, all other embodiments obtained by a person of ordinary skill in the art without inventive efforts, shall fall within the scope of protection of the present invention.

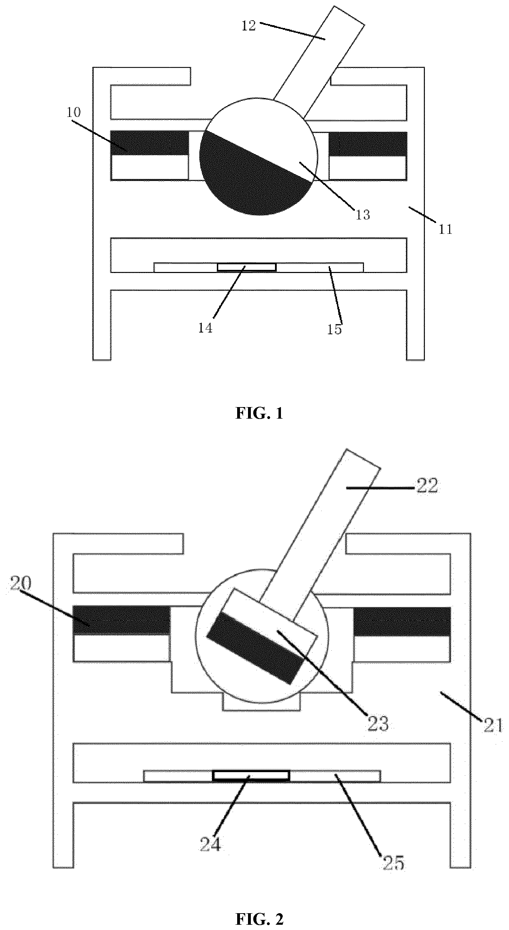

Referring to FIG. 1, in the first embodiment, the present invention provides a rocker device with an automatic center returning function, including: a ring magnet 10 with a circular aperture, a fixed member 11, a magnet inside ring 13 fixedly connected to the rocker 12, and a magnetic sensor chip 14 arranged on a PCB board 15.

In the above, the ring magnet 10 is magnetized in thickness, and a line connecting N-S poles is perpendicular to a circular section of the circular aperture. The fixed member 11 is made of a non-magnetic material; and is arranged with the ring magnet 10 in a stacked manner in a perpendicular direction of the circular section. The first chamber wraps other sides of the ring magnet 10 beside an inner side of the ring to fix the ring magnet 10.

The magnet inside ring 13 is fixedly connected to one end of the rocker 12, and is a spherical magnet with the N-S poles being of completely symmetrical shapes. The magnet inside ring 13 is supported by the fixed member 11 and arranged in a center of the circular aperture of the ring magnet 10. When the rocker 12 has been returned to the center, the line connecting the N-S poles of the magnet inside ring 13 is perpendicular to the circular section of the circular aperture.

The magnetic sensor chip 14 is configured to detect a rotation angle of the rocker and is arranged on a PCB board 15, wherein the PCB board 15 is arranged in the second chamber of the fixed member 11. The second chamber is located below the first chamber, and the first chamber and second chamber are separated from each other. The magnetic sensor chip 14 is arranged below the magnet inside ring 13 in the direction perpendicular to the circular section of the circular aperture of the ring magnet 10.

In the second embodiment shown in FIG. 2, the rocker device also includes a ring magnet 20 with a circular aperture, a fixed member 21, a magnet inside ring 23 fixedly connected to the rocker 22, and a magnetic sensor chip 24 arranged on a PCB board 25. The only difference from the embodiment shown in FIG. 1 is that the magnet inside ring 23 in FIG. 2 is a cylindrical magnet wrapped in a spherical non-magnetic material. In other embodiments, the magnet inside ring is a square magnet wrapped in a spherical non-magnetic material.

The work principles of the rocker device provided by the present invention to realize the automatic returning to the center are as follows.

When the magnet inside ring (spherical, cylindrical, or square) is placed inside a ring permanent magnet (which are all magnetized in thickness), the magnet will randomly be attracted to the inner wall of the ring magnet based on the principle that same poles repel and opposite poles attract. When the magnet inside ring is located on an absolute center of the ring magnet, a steady state will be kept due to equal suction forces of two sides of the magnetic fields. At this time, the magnet inside ring is supported by the fixed member under the ring magnet, so as to ensure that the magnet inside ring is in a central stable state. When the magnet inside ring is driven by the rocker to rotate towards any direction at any angle, the magnetic sensor chip placed below the magnet inside ring detects the rotation angle of the rocker by sensing the change of the magnetic field at this position and parallel to the circular section of the circular aperture (taking a normal direction of the circular section as the Z-axis, the magnetic sensor chip detects the change of the magnetic field parallel to the X-axis and Y-axis directions).

When the magnet inside ring rotates towards any direction at any angle when subjected to external forces (driven by the rocker), since the same poles of the magnet inside ring and the ring magnet are exclusive to each other, it will return to a stable state under the effect of magnetic force. In this way, the function of the rocker automatically returning to the center via the rotation is substantially realized. It is obvious that the rocker device provided by the present invention does not need to adopt the cardan shaft and spring used in the conventional rocker, and is free from the metal fatigue.

Preferably, the magnetic sensor chip is implemented based on XMR reluctance unit or Hall sensor, wherein the XMR comprises TMR, AMR, and GMR.

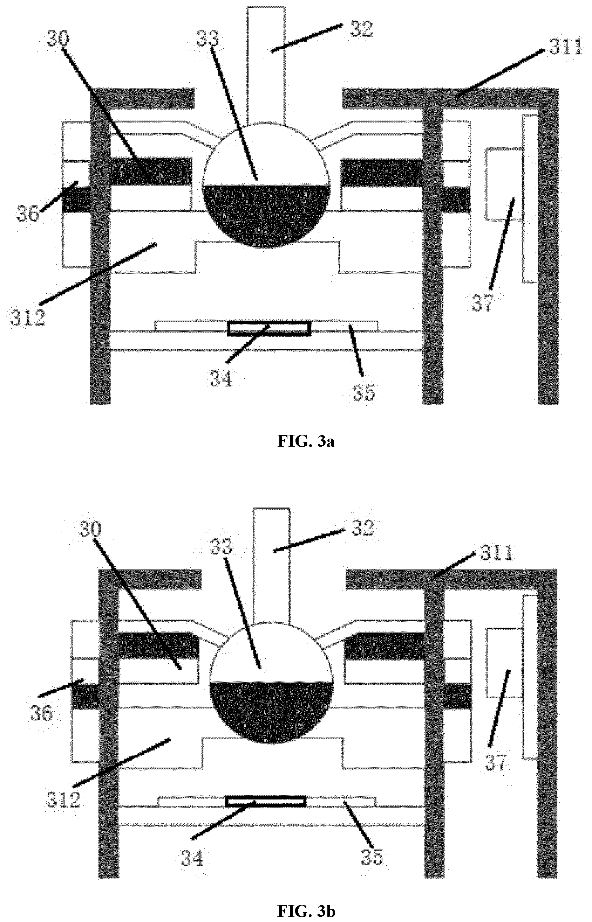

Furthermore, several outer magnets can be added to the outer side of the ring magnet to achieve the functions of the automatic returning to the center and the press detection of the rocker. As shown in FIG. 3a, the ring magnet 30 is fixed on the first component 311 of the fixed member, and an outer magnet 36 is added to the second component 312 of the fixed member corresponding to the outer ring side of the ring magnet 30. By partially opening a hollow groove in the second component 312, the first component 311 and the second component 312 are interlocked to achieve downward movement of the second component 312 relative to the first component 311 when the rocker 32 is pressed. The outer magnet 36 slides down as the rocker 32 is pressed, which is driven by the second component 312 of the fixed member. When the rocker 32 is not pressed, the N pole of the outer magnet 36 is aligned with the S pole of the ring magnet, and the S pole of the outer magnet is aligned with the N pole of the ring magnet. With the magnetic force between the ring magnet 30 and the outer magnet 36, as well as the transmission effect of the second component 312 of the fixing member on the magnet inside ring 33, the rocker maintains a stable initial state (the same state as when it has rotated back to center and pressed back to center).

As shown in FIG. 3b, when the rocker 32 is shaken, the deviation angle of the rocker 32 is detected by the magnetic sensor chip 34 set on the PCB board 35. When the rocker 32 is pressed, the outer magnet 36 slides downward relative to the ring magnet 30 under the driving of the second component 312 of the fixed member, resulting in a change in the relative position between the N and S poles of the outer magnet 36 and the ring magnet 30. At this time, there is only one pair of same magnetic poles facing each other between the outer magnet 36 and the ring magnet 30. As shown in FIG. 3b, when the rocker 32 is pressed down, the same magnetic poles of the outer magnet 36 and the ring magnet 30 are at the same horizontal position, and repulsive force is generated between the same magnetic poles of the two, while attractive force is generated between the different magnetic poles, such that the magnetic attraction force is generated between the outer magnet 36 and the ring magnet 30. The magnetic attraction force pushes the relative positions of the two back to the state before the rocker 32 was pressed (the position of the ring magnet 30 is fixed on the first component 311), and then through the transmission effect of the second component 312 of the fixed member, the rocker 32 is automatically pressed back into the center. Correspondingly, a pressing sensor 37 is fixedly added outside the outer magnet 36, independent of the outer magnet 36, to detect the press state of the rocker 32. The pressing sensor 37 is set as a magnetic sensor, which detects whether the rocker 32 is pressed by detecting the magnetic field changes generated by the movement of the outer magnet at its own installation location.

Obviously, through adjusting the size of the magnets fixedly connected to the rocker and the size of the magnet ring, the manipulation feel of the rocker device provided by the present invention can be conveniently adjusted.

Compared with the prior rocker devices, the rocker device provided by the present invention has the higher detection accuracy and service life, and the detection and the automatic returning to the center for the rocker can be realized without adopting the spring and carbon film structure, so that it does not exist the problems caused by metal fatigue. At the same time, the rocker device provided by the present invention adopts the non-contact magnetic transmission, which greatly simplifies the transmission structure of the rocker, reduces the cost, and increases the life of the rocker.

The foregoing are merely optional embodiments of the present invention, and are not configured to limit the present invention. For those skilled in the art, the present invention may have various changes and variations, and any modifications, equivalent replacements, improvements, etc., made within the spirit and principles of the present invention, shall be included within the scope of protection of the present invention. The foregoing are only the embodiments of the present invention, but the scope of protection of the present invention is not limited thereto. Any technical personnel familiar with the technical field can easily think of changes or replacements within the technical scope of the present invention, shall be covered by the scope of protection of the present invention. Therefore, the scope of protection of the present invention should be governed by the scope of protection of claims.

## Claims

1. A rocker device with an automatic center returning function, **characterized in that** the rocker device comprises: a ring magnet (30) with a circular aperture, a fixed member (11, 21), a magnet inside ring (13, 23, 33) fixedly connected to the rocker (12, 22, 32), and a magnetic sensor chip (14, 24, 34), wherein
the ring magnet (30) is magnetized in thickness, and a line connecting N-S poles is perpendicular to a circular section of the circular aperture;
the fixed member (11, 21) is made of a non-magnetic material, and is arranged with the ring magnet (30) in a stacked manner in a perpendicular direction of the circular section and the ring magnet (30) is fixed;
N-S poles of the magnet inside ring (13, 23, 33) are completely symmetrical in shape, and are supported by the fixed member (11, 21) and arranged in a center of the circular aperture of the ring magnet (30), wherein when the rocker (12, 22, 32) is in a state of having been rotated to return to a center, a line connecting the N-S poles of the magnet inside ring (13, 23, 33) is perpendicular to the circular section of the circular aperture; and
the magnetic sensor chip (14, 24, 34) is configured to detect a rotation angle of the rocker (12, 22, 32), and is located below the magnet inside ring (13, 23, 33) in a direction perpendicular to the circular section of the circular aperture.

2. The rocker device according to claim 1, wherein the magnet inside ring (13, 23, 33) is a spherical magnet.

3. The rocker device according to claim 1, wherein the magnet inside ring (13, 23, 33) is a cylindrical magnet or a square magnet wrapped in a spherical non-magnetic material.

4. The rocker device according to any one of claims 1-3, wherein the fixed member (11, 21) comprises a first component (311) and a second component (312), wherein the first component (311) and the second component (312) are interlocked by providing a hollow groove in a partial second component (312); the ring magnet (30) is fixed on the first component (311), and an outer magnet (36) is added to the second component (312) corresponding to an outer ring side of the ring magnet (30), wherein the outer magnet (36) slides downward relative to the first component (311) as the rocker (12, 22, 32) is pressed, which is driven by the second component (312); when the rocker (12, 22, 32) is not pressed, an N pole of the outer magnet (36) is aligned with an S pole of the ring magnet (30), and an S pole of the outer magnet (36) is aligned with an N pole of the ring magnet (30); and when the rocker (12, 22, 32) is pressed, only one pair of same magnetic poles facing each other exist between the outer magnet (36) and the ring magnet (30).

5. The rocker device according to claim 4, wherein the rocker device further comprises a press sensor, wherein the press sensor on the first component (311) is fixedly arranged outside and independent of the outer magnet (36) wherein the press sensor is a magnetic sensor, and configured to detect a press state of the rocker (12, 22, 32) by detecting a movement of the outer magnet (36).

6. The rocker device according to claim 1, wherein the magnetic sensor chip (14, 24, 34) is realized based on a XMR reluctance unit or a Hall sensor, wherein the XMR comprises TMR, AMR, and GMR.
